# EUROPEAN PATENT SPECIFICATION

(11) **EP 2 317 518 B1**
(45) Date of publication and mention of the grant of the patent: **12.10.2011**
(21) Application number: 09174755.0
(22) Date of filing: 02.11.2009
(51) Int. Cl.: G11C 7/10

(54) **Flash memory accessing apparatus and method thereof**
Flash-Speicherzugangsvorrichtung und Verfahren dafür
Appareil d'accès à mémoire flash et son procédé

(43) Date of publication of application: 04.05.2011
(73) Proprietor: Giga-Byte Technology Co., Ltd., Taipei 231 (TW)
(72) Inventor: Lin, Hou-Yuan, 231, Hsin Tien, Taipei County (TW); Chen, Chen-Sun, 231, Hsin Tien, Taipei County (TW)
(74) Representative: Schwerbrock, Florian

(56) References cited:
- US-A1- 2005 223 158
- US-A1- 2006 109 725
- US-A1- 2006 155 979

## Description

BACKGROUND OF THE INVENTION

Field of the Invention

The present invention relates to a flash memory accessing apparatus and a method thereof, and more particularly to a dual-channel flash memory accessing apparatus and a method thereof.

Description of Related Art

The flash memory is an electrically programmable read only memory which can be erased or programmed several times during operations. Usually, the flash memory includes the NOR flash memory or the NAND flash memory. No matter the flash memory is the NOR flash memory or the NAND flash memory, there is the number of times to erase or program the flash memory is limited. Taking the NAND flash memory as an example, the number of times to erase or program the multi-level cell NAND flash memory is usually about ten thousands. Also, the number of times to erase or program the single-level cell NAND flash memory is usually about hundred thousands.

In the current technology, there is a dual channel flash memory accessing apparatus. When this conventional dual channel flash memory accessing apparatus stores data, the data is divided into two data sections. The two data sections are stored into different flash memories through different channels at the same time. Therefore, the rate for storing data into the flash memories effectively doubles. That is, the bandwidth for accessing the data by the flash memory accessing apparatus doubles.

However, the flash memory may be damaged due to too many times of being erased or programmed. In the aforementioned dual channel flash memory accessing apparatus, when the flash memory of one of the channel is damaged, the data stored in the damaged flash memory is lost forever. That is, it is highly possible that the data in the flash memory can not be restored once the flash memory in the conventional dual channel flash memory accessing apparatus is damaged.
US 2005/223158 discloses a dual-channel flash memory comprising first and second flash memories and a flash memory controller.
US 2006/155979 discloses a main flash memory coupled to a backup flash memory.
US 2006/109725 discloses a flash memory having a chip portion dedicated to provide a redundant backup copy of data stored elsewhere in the chip.

SUMMARY OF THE INVENTION

The invention provides a flash memory accessing apparatus and method thereof for providing a dual channel flash memory set capable of increasing the transmission bandwidth and providing data backup ability.

The invention provides a flash memory accessing apparatus comprising a controller, a first channel memory set and a second channel memory set. The first channel memory set is coupled to the controller through a first channel and comprises a first flash memory and at least a first memory expanding socket. The first flash memory is coupled to the controller, and the first memory expanding socket is coupled to the first flash memory and the controller. The second channel memory set is coupled to the controller through a second channel. The second channel memory set comprises a second flash memory coupled to the controller and a second memory expanding socket coupled to the second flash memory and the controller. The controller determines a reading operation or a programming operation to be implemented on the first flash memory and the second flash memory according to a detection of a flash memory insertion state of each of the first memory expanding socket and the second memory expanding socket.

According to one embodiment of the present invention, when the first memory expanding socket is connected to a third flash memory and the second memory expanding socket is connected to a fourth flash memory, the controller determines each of the first flash memory, the second flash memory, the third flash memory and the fourth flash memory as a main memory or a backup memory according to whether the reading operation or the programming operation is normally implemented on the first flash memory, the second flash memory, the third flash memory and the fourth flash memory.

According to one embodiment of the present invention, the controller determines the first flash memory and the second flash memory as the main memories and determines the third flash memory and the fourth flash memory as the backup memories when the controller detects the reading operation or the programming operation is normally implemented on each of the first flash memory, the second flash memory, the third flash memory and the fourth flash memory. Alternatively, the controller determines the third flash memory and the fourth flash memory as the main memories and determines the first flash memory and the second flash memory as the backup memories. It should be noticed that the flash memories configured in the same channel memory set can be the backup memories of each other.

According to one embodiment of the present invention, the third flash memory is used to store a copy of a data stored in the first flash memory and the fourth flash memory is used to store a copy of a data stored in the second flash memory.

According to one embodiment of the present invention, the first flash memory is used to store a copy of a data stored in the third flash memory and the second flash memory is used to store a copy of a data stored in the fourth flash memory.

According to one embodiment of the present invention, the controller determines the second flash memory as the main memory and determines the fourth flash memory as the backup memory when the controller detects the reading operation or the programming operation is abnormally implemented on each of the first flash memory and the third flash memory in the first channel memory set. Alternatively, the controller determines the fourth flash memory as the main memory and determines the second flash memory as the backup memory.

According to one embodiment of the present invention, the controller determines the first flash memory as the main memory and determines the third flash memory as the backup memory when the controller detects the reading operation or the programming operation is abnormally implemented on each of the second flash memory and the fourth flash memory in the second channel memory set. Alternatively, the controller determines the third flash memory as the main memory and determines the first flash memory as the backup memory.

According to an embodiment of the present invention, the first channel memory set, the second channel memory set and the controller are configured on a circuit board.

According to one embodiment of the present invention, the first channel memory set and the controller are configured on a circuit board and the second channel memory set is an open-type NAND flash memory interface set.

According to one embodiment of the present invention, the controller is configured on a circuit board and each of the first channel memory set and the second channel memory set is an open-type NAND flash memory interface set.

According to one embodiment of the present invention, the controller is configured on a circuit board, and each of the first channel memory set and the second channel memory set is an open-type NAND flash memory interface set and is directly configured on the circuit board.

The invention further provides an accessing method of a flash memory comprising providing a controller for implementing a reading operation or a programming operation on a first flash memory and a second flash memory in a first channel memory set and on a third flash memory and a fourth flash memory in a second channel memory set. Then, the controller determines whether each of the first flash memory, the second flash memory, the third flash memory and the fourth flash memory respectively in the first channel memory set and in the second channel memory set is normal according to the reading operation or the programming operation. The controller determines each of the first flash memory, the second flash memory, the third flash memory and the fourth flash memory as a main memory or a backup memory according to whether each of the first flash memory, the second flash memory, the third flash memory and the fourth flash memory is normally operated.

According to the above description, each of the flash memory sets of the present invention equipped with the flash memories as the backup memories. Thus, the data stored in the main flash memories can be copied into the backup memories. Moreover, it can effectively restore the data in the flash memory while it is damaged due to too many times of erasing operation and programming operation. Furthermore, in the present invention, by detecting whether the reading operation or the programming operation is normally implemented, the flash memories in the dual channel memory set can be determined to be the main memories for storing data and the backup memories for storing the copies of the data stored in the main memories. Therefore, the undamaged memories can be efficiently used to present the maximum efficacy thereof.

In order to make the aforementioned and other features and advantages of the invention more comprehensible, embodiments accompanying figures are described in detail below.

BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

Fig. 1 is a schematic view showing a flash memory accessing apparatus 100 according to one embodiment of the present invention.

Fig. 2 is a schematic view showing a flash memory designing method of the flash memory accessing apparatus 100.

Fig. 3 is a schematic view showing a flash memory accessing apparatus 300 according to the other embodiment of the present invention.

Fig. 4 is a schematic view showing an accessing method of a flash memory according to one embodiment of the present invention.

DESCRIPTION OF EMBODIMENTS

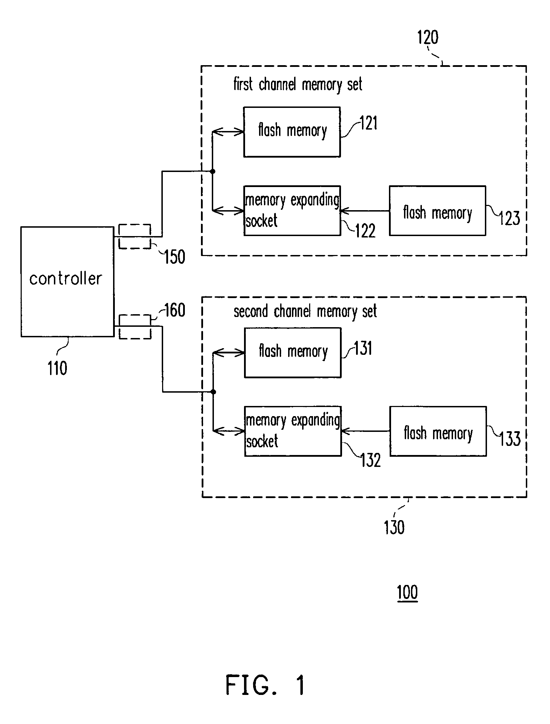

Fig. 1 is a schematic view showing a flash memory accessing apparatus 100 according to one embodiment of the present invention. As shown in Fig. 1, a flash memory accessing apparatus 100 comprises a controller 110, a first channel memory set 120 and a second channel memory set 130. Furthermore, the controller 110 is coupled to the first channel memory set 120 through a first channel 150, and the controller is coupled to the second channel memory set 130 through a second channel 160. The first channel memory set 120 comprises a flash memory 121 and a memory expanding socket 122, and the second channel memory set 130 comprises a flash memory 131 and a memory expanding socket 132. The flash memory 121 and the memory expanding socket 122 are coupled to each other and coupled to the controller 110, and the flash memory 131 and the memory expanding socket 132 are coupled to each other and coupled to the controller 110.

When there is no memory inserted into the memory expanding sockets 122 and 132, the controller 110 accesses the flash memories 121 and 131 through the first channel 150 and the second channel 160 respectively in a dual channel method according to a flash memory insertion-less state of the memory expanding sockets 122 and 132 detected by the controller 110.

Alternatively, when the memory expanding sockets 122 and 132 are connected to the flash memory 123 and 133 respectively as shown in Fig. 1, the controller 110 implements a test on the flash memories 121, 123, 131 and 133 respectively in the first channel memory set 120 and the second channel memory set 130 according to a flash memory insertion state of the memory expanding sockets 122 and 132 detected by the controller 110 during the actual operation of the flash memory accessing apparatus 100. The main purpose of this test is to determine whether the flash memories 121, 123, 131 and 133 are damaged. In other words, the controller 110 implements the reading operation or programming operation on the flash memories 121, 123, 131 and 133, and when the controller can normally implement the reading operation or the programming operation on the flash memory 121, for example, it is determined that the flash memory 121 is not damaged. When the controller cannot normally implement the reading operation or the programming operation on the flash memory 121, it is determined the flash memory 121 is damaged.

Thereafter, the controller 110 determines each of the flash memories as the main memory or the backup memory according to whether the reading operation or the programming operation can be normally implemented on the flash memories 121, 123, 131 and 133. The main memory is used to store the data and the backup memory is used to store the copies of the data stored in the main memory.

It should be noticed that the controller 110 periodically implements the detection operation for determining whether the reading operation or the programming operation of the flash memories 121, 123, 131 and 133 is normal. Because the flash memory may be damaged due to too many times of erasing operation and programming operation, the controller 110 needs to know whether the flash memories 121, 123, 131 and 133 in the flash memory accessing apparatus 100 are damaged and to dynamically adjust which of the flash memories is the main memory and which of the flash memories is the backup memory.

The following description details the controller 110 of the present embodiment implementing the designing method of the flash memories 121, 123, 131 and 133 according to whether the reading operation or the programming operation can be normally implemented on the flash memories 121, 123, 131 and 133, which is determined by the controller 110, so that the people skilled in the art can further understand the details of the present embodiment.

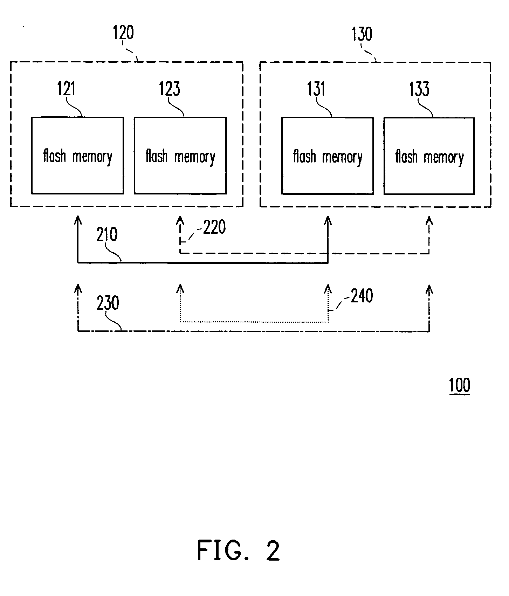

As shown in Fig. 1 and Fig. 2, Fig. 2 shows four possible allocating methods when the controller detects that the reading operation or the programming operation can be normally implemented on the flash memories 121, 123, 131 and 133. The controller 110 can determine the flash memory 121 and the flash memory 131 to be the main memories. Further, the flash memory 123 and the flash memory 133 are determined as the backup memories. The flash memory 123 can be used to store the copy of the data stored in the flash memory 121. Similarly, the flash memory 133 can be used to store the copy of the data stored in the flash memory 131. The controller 110 can also determine the flash memory 123 and the flash memory 133 to be the main memories (as indicated by the dotted line 220). Further, the flash memory 121 and the flash memory 131 are determined as the backup memories. The flash memory 121 can be used to store the copy of the data stored in the flash memory 123. Similarly, the flash memory 131 can be used to store the copy of the data stored in the flash memory 133.

Furthermore, the controller 110 can also determine the flash memory 121 and the flash memory 133 to be the main memories (as indicated by the dotted line 230). Further, the flash memory 123 and the flash memory 131 are determined as the backup memories. The flash memory 123 can be used to store the copy of the data stored in the flash memory 121. Similarly, the flash memory 131 can be used to store the copy of the data stored in the flash memory 133. Alternatively, the controller 110 can also determine the flash memory 123 and the flash memory 131 to be the main memories (as indicated by the dotted line 240). Further, the flash memory 121 and the flash memory 133 are determined as the backup memories. The flash memory 121 can be used to store the copy of the data stored in the flash memory 123. Similarly, the flash memory 133 can be used to store the copy of the data stored in the flash memory 131.

It can be easily understood that when the flash memories 121, 123, 131 and 133 are not damaged, the controller 110 can determines any of the flash memories in the first channel memory set 120 to be the main memory and determines the other flash memory in the first channel memory set 120 to be the backup memory. Meanwhile, the controller can determines any of the flash memories in the second channel memory set 130 to be the main memory and determines the other flash memory in the second channel memory set 130 to be the backup memory. Therefore, the flash memory accessing apparatus 100 can maintain the dual channel accessing method so that the data to be stored can be divided and then the divided data can be respectively stored into the maim memories in the first channel memory set 120 and the second channel memory set 130 at the same time.

It should be noticed that, in the method for backing-up data in the main memory into the backup memory, the controller 110 can periodically duplicate the data in the main memory into the backup memory. That is, the counter (not shown) to count the time, and when the counting number equals the predetermined cycle time, the controller 110 implements a backup operation to duplicate the data in the main memory to the backup memory so that the data in the main memory can be backup periodically to preserve the security of the data.

The aforementioned data backup method is only an exemplar embodiment and is not used to limit the present invention for only using the aforementioned data backup method to backup the data. The data backup methods well known by the people skilled in the art can be also applied on the embodiment of the present invention.

Alternatively, since the controller 110 can real-time detect whether the reading operation or the programming operation is normally implemented on the flash memories 121, 123, 131 and 133 to real-time control the states of the flash memories 121, 123, 131 and 133, the controller 110, for example, can re-determine the flash memory 123 used to be the backup memory of the flash memory 121 to be the main memory once the flash memory 121 as the main memory is damaged so that the flash memory accessing apparatus 100 can still normally operate.

As shown in Fig. 1, when the controller 110 detects the reading operation or the programming operation is abnormally implemented on the flash memories 121 and 123 in the first channel memory set 120, the controller 110 determines one of the flash memories 131 and 133 in the second channel memory set 130 as the main memory and determines the other one of the flash memories 131 and 133 in the second channel memory set 130 as the backup memory. Similarly, when the controller 110 detects the reading operation or the programming operation is abnormally implemented on the flash memories 131 and 133 in the second channel memory set 130, the controller 110 determines one of the flash memories 121 and 123 in the first channel memory set 120 as the main memory and determines the other one of the flash memories 121 and 123 in the first channel memory set 120 as the backup memory.

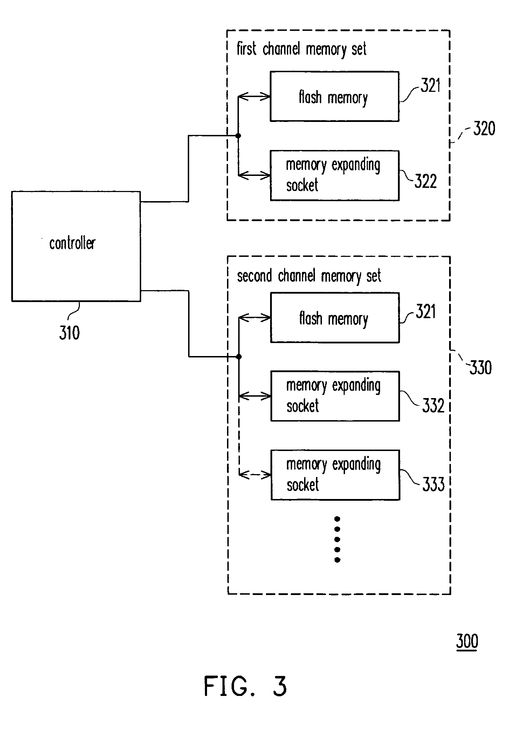

Fig. 3 is a schematic view showing a flash memory accessing apparatus 300 according to one embodiment of the present invention. As shown in Fig. 3, a flash memory accessing apparatus 300 comprises a controller 310, a first channel memory set 320 and a second channel memory set 330. The first channel memory set 320 comprises a flash memory 321 and a memory expanding socket 322, and the second channel memory set 330 comprises a flash memory 331. The difference between the flash memory accessing apparatus 100 in the previous embodiment and the flash memory accessing apparatus 300 in the present embodiment, the second channel memory set 330 of the flash memory accessing apparatus 300 further comprises several memory expanding socket 332 and 333. The memory expanding sockets 332 and 333 are coupled to the controller 310 and coupled to the flash memory 331 for connecting more flash memories. The flash memory connected to the memory expanding socket 333 can be used as the backup memory. Moreover, the first channel memory set 320 can also equipped with several memory expanding sockets.

It should be noticed that the controller 310, the first channel memory set 320 and the second channel memory set 330 in the aforementioned embodiment can be configured on a circuit board, such as a mother board. Alternatively, the controller 310 is configured on the circuit board and the first channel memory set 320 and the controller 310 are configured on the same circuit board, wherein the second channel memory set 330 is an open-type NAND flash memory interface set. Further, the controller 310 is configured on the circuit board, and each of the first channel memory set 320 and the second channel memory set 330 is an open-type NAND flash memory interface set, wherein the first channel memory set 320 and the second channel memory set 330 can be, but are not necessary, configured on the circuit board as same as which the controller is configured on.

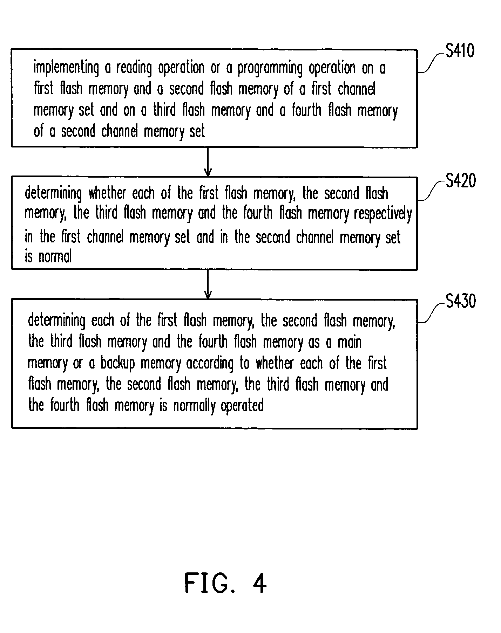

Fig. 4 is a schematic view showing an accessing method of a flash memory according to one embodiment of the present invention. As shown in Fig. 4, a controller is provided for implementing a reading operation or a programming operation on a first flash memory and a second flash memory of a first channel memory set and on a third flash memory and a fourth flash memory of a second channel memory set (step S410). Then, the controller determines whether each of the first flash memory, the second flash memory, the third flash memory and the fourth flash memory respectively in the first channel memory set and in the second channel memory set is normal according to the reading operation or the programming operation (step S420). The controller determines each of the first flash memory, the second flash memory, the third flash memory and the fourth flash memory as a main memory or a backup memory according to whether each of the first flash memory, the second flash memory, the third flash memory and the fourth flash memory is normally operated(step S430).

Moreover, the method for the controller determining each of the flash memories as the main memory or the backup memory according to whether each of the flash memories is normally operated is detailed described in the previous two embodiments about the flash memory accessing apparatuses 100 and 300 and is not further described herein.

According to the above description, the present invention provides a flash memory accessing apparatus and an accessing method of a dual channel memory set. According to whether each of the flash memories in the first channel memory set and the second channel memory set is damaged, the controller of the flash memory accessing apparatus determines each of the flash memories as the main memory or the backup memory. Therefore, the data stored in the main memory can be backup into the backup memory without being lost. Further, when the main memory is damaged, the controller can dynamically switch the backup memory to be the main memory to maintain the normal operation of the flash memory accessing apparatus.

## Claims

1. A flash memory accessing apparatus, comprising:
a controller (110);
a first channel memory set(120) coupled to the controller (110) through a first channel(150), wherein the first channel memory set(120) comprises:
a first flash memory (121) coupled to the controller (110); and
at least a first flash memory (121) expanding socket coupled to the first flash memory (121) and the controller (110); and
a second channel memory set(130) coupled to the controller (110) through a second channel (160), wherein the second channel memory set(130) comprises:
a second flash memory (131) coupled to the controller (110); and
at least a second flash memory (131) expanding socket coupled to the second flash memory (131) and the controller (110);
**characterized in that** the controller (110) is adapted to determine a reading operation or a programming operation to be implemented on the first flash memory (121) and the second flash memory (131) according to a detection of a flash memory insertion state of each of the first memory expanding socket (122) and the second memory expanding socket (132); then, when the first memory expanding socket (122) is connected to a third flash memory (123) and the second memory expanding socket (132) is connected to a fourth flash memory (133), the controller (110) is adapted to determine each of the first flash memory (121), the second flash memory (131), the third flash memory (123) and the fourth flash memory (133) as a main memory or a backup memory according to whether the reading operation or the programming operation is normally implemented on the first flash memory (121), the second flash memory (131), the third flash memory (123) and the fourth flash memory (133).

2. The flash memory accessing apparatus of claim 1, wherein the controller (110) further switches the backup memory to be the main memory when the reading operation or the programming operation is detected to be abnormally implemented on the main memory.

3. The flash memory accessing apparatus of claim 1, wherein the controller (110) determines the first flash memory (121) and the second flash memory (131) as the main memories and determines the third flash memory (123) and the fourth flash memory (133) as the backup memories when the reading operation or the programming operation is detected to be normally implemented on each of the first flash memory (121), the second flash memory (131), the third flash memory (123) and the fourth flash memory (133).

4. The flash memory accessing apparatus of claim 3, wherein the third flash memory (123) is used to store a copy of a data stored in the first flash memory (121) and the fourth flash memory (133) is used to store a copy of a data stored in the second flash memory (131).

5. The flash memory accessing apparatus of claim 1, wherein the controller (110) determines the second flash memory (131) as the main memory and determines the fourth flash memory (133) as the backup memory when the reading operation or the programming operation is detected to be abnormally implemented on each of the first flash memory (121) and the third flash memory (123) in the first channel memory set (120).

6. The flash memory accessing apparatus of claim 1, wherein the controller (110) determines the first flash memory (121) as the main memory and determines the third flash memory (123) as the backup memory when the reading operation or the programming operation is detected to be abnormally implemented on each of the second flash memory (131) and the fourth flash memory (133) in the second channel memory set (130).

7. The flash memory accessing apparatus of claim 1, wherein the first channel memory set(120), the second channel memory set(130) and the controller (110) are configured on a circuit board.

8. The flash memory accessing apparatus of claim 1, wherein the first channel memory set(120) and the controller (110) are configured on a circuit board and the second channel memory set (130) is an open-type NAND flash memory interface set.

9. The flash memory accessing apparatus of claim 1, wherein the controller (110) is configured on a circuit board and each of the first channel memory set (120) and the second channel memory set(130) is an open-type NAND flash memory interface set.

10. The flash memory accessing apparatus of claim 1, wherein the controller (110) is configured on a circuit board, and each of the first channel memory set(120) and the second channel memory set(130) is an open-type NAND flash memory interface set and is directly configured on the circuit board.

11. An accessing method of a flash memory, comprising:
providing a controller for implementing a reading operation or a programming operation on a first flash memory and a second flash memory of a first channel memory set and on a third flash memory and a fourth flash memory of a second channel memory set(step S410);
determining whether each of the first flash memory, the second flash memory, the third flash memory and the fourth flash memory respectively in the first channel memory set and in the second channel memory set is normal by the controller according to the reading operation or the programming operation (step S420); and
determining each of the first flash memory, the second flash memory, the third flash memory and the fourth flash memory as a main memory or a backup memory by the controller according to whether each of the first flash memory, the second flash memory, the third flash memory and the fourth flash memory is normally operated(step S430).

12. The accessing method of claim 11, further comprising:
switching the backup memory to be the main memory by the controller when controller detects the reading operation or the programming operation is abnormally implemented on the main memory.

13. The accessing method of claim 11, wherein the step of determining each of the first flash memory, the second flash memory, the third flash memory and the fourth flash memory as a main memory or a backup memory by the controller according to whether each of the first flash memory, the second flash memory, the third flash memory and the fourth flash memory is normally operated comprises:
determining the first flash memory and the third flash memory as the main memories and determining the second flash memory and the fourth flash memory as the backup memories by the controller when the controller detects the reading operation or the programming operation is normally implemented on each of the first flash memory, the second flash memory, the third flash memory and the fourth flash memory.

14. The accessing method of claim 11, wherein the second flash memory is used to store a copy of a data stored in the first flash memory and the fourth flash memory is used to store a copy of a data stored in the third flash memory.

15. The accessing method of claim 11, wherein the step of determining each of the first flash memory, the second flash memory, the third flash memory and the fourth flash memory as a main memory or a backup memory by the controller according to whether each of the first flash memory, the second flash memory, the third flash memory and the fourth flash memory is normally operated comprises:
determining the third flash memory as the main memory and determining the fourth flash memory as the backup memory by the controller when the controller detects the reading operation or the programming operation is abnormally implemented on each of the first flash memory and the second flash memory in the first channel memory set.

16. The accessing method of claim 11, wherein the step of determining each of the first flash memory, the second flash memory, the third flash memory and the fourth flash memory as a main memory or a backup memory by the controller according to whether each of the first flash memory, the second flash memory, the third flash memory and the fourth flash memory is normally operated comprises:
determining the first flash memory as the main memory and determining the second flash memory as the backup memory by the controller when the controller detects the reading operation or the programming operation is abnormally implemented on each of the third flash memory and the fourth flash memory in the second channel memory set.

17. The accessing method of claim 11, further comprising:
further providing at least an expanding memory to be the backup memory in the first channel memory set.

18. The accessing method of claim 11, further comprising:
further providing at least an expanding memory to be the backup memory in the second channel memory set.

## Patentansprüche

1. Flash-Speicher-Zugangsvorrichtung umfassend:
ein Steuergerät (110);
einen ersten Kanalspeichersatz (120), der mit dem Steuergerät (110) durch einen ersten Kanal (150) gekoppelt ist, wobei der erste Kanalspeichersatz (120) folgendes umfasst:
einen ersten Flash-Speicher (121), der mit dem Steuergerät (110) gekoppelt ist; und
mindestens einen ersten Flash-Speicher-(121)-Erweiterungssockel, der mit dem ersten Flash-Speicher (121) und dem Steuergerät (110) gekoppelt ist; und
einen zweiten Kanalspeichersatz (130), der mit dem Steuergerät (110) durch einen zweiten Kanal (160) gekoppelt ist, wobei der zweite Kanalspeichersatz (130) folgendes umfasst:
einen zweiten Flash-Speicher (131), der mit dem Steuergerät (110) gekoppelt ist; und
mindestens einen zweiten Flash-Speicher-(131)-Erweiterungssockel, der mit dem zweiten Flash-Speicher (131) und dem Steuergerät (110) gekoppelt ist;
**dadurch gekennzeichnet, dass** das Steuergerät (110) so ausgeführt ist, dass nach einer Erkennung des Einsteckzustands des ersten Speicher-Erweiterungssockels (122) und des zweiten Speicher-Erweiterungssockels (132) ein Lese- oder Programmierbetrieb am ersten Flash-Speicher (121) und am zweiten Flash-Speicher (131) implementiert wird; woraufhin, wenn der erste Speicher-Erweiterungssockel (122) mit einem dritten Flash-Speicher (123) verbunden wird und der zweite Speicher-Erweiterungssockel (132) mit einem vierten Flash-Speicher (133) verbunden wird, das Steuergerät (110) so ausgeführt ist, dass er den ersten Flash-Speicher (121), den zweiten Flash-Speicher (131), den dritten Flash-Speicher (123) und den vierten Flash-Speicher (133) als Hauptspeicher oder Sicherungsspeicher bestimmt, je nachdem, ob der Lese- oder Programmierbetrieb normal am ersten Flash-Speicher (121), am zweiten Flash-Speicher (131), am dritten Flash-Speicher (123) und am vierten Flash-Speicher (133) implementiert ist.

2. Flash-Speicher-Zugangsvorrichtung nach Anspruch 1, wobei das Steuergerät (110) ferner den Sicherungsspeicher als Hauptspeicher schaltet, wenn der Lese- oder Programmierbetrieb als nicht normal am Hauptspeicher implementiert erkannt wird.

3. Flash-Speicher-Zugangsvorrichtung nach Anspruch 1, wobei das Steuergerät (110) den ersten Flash-Speicher (121) und den zweiten Flash-Speicher (131) als Hauptspeicher und den dritten Flash-Speicher (123) und en vierten Flash-Speicher (133) als Sicherungsspeicher bestimmt, wenn der Lese- oder Programmierbetrieb am ersten Flash-Speicher (121), dem zweiten Flash-Speicher (131), dem dritten Flash-Speicher (123) und dem vierten Flash-Speicher (133) als normal implementiert erkannt wird.

4. Flash-Speicher-Zugangsvorrichtung nach Anspruch 3, wobei der dritte Flash-Speicher (123) dazu verwendet wird, eine Kopie der im ersten Flash-Speicher (121) gespeicherten Daten zu speichern und der vierte Flash-Speicher (133) dazu verwendet wird, eine Kopie der im zweiten Flash-Speicher (131) gespeicherten Daten zu speichern.

5. Flash-Speicher-Zugangsvorrichtung nach Anspruch 1, wobei das Steuergerät (110) den zweiten Flash-Speicher (131) als Hauptspeicher und den vierten Flash-Speicher (133) als Sicherungsspeicher bestimmt, wenn der Lese- oder Programmierbetrieb am ersten Flash-Speicher (121) und am dritten Flash-Speicher (123) im ersten Kanalspeichersatz (120) als nicht normal implementiert erkannt wird.

6. Flash-Speicher-Zugangsvorrichtung nach Anspruch 1, wobei das Steuergerät (110) den ersten Flash-Speicher (121) als Hauptspeicher und den dritten Flash-Speicher (123) als Sicherungsspeicher bestimmt, wenn der Lese- oder Programmierbetrieb am zweiten Flash-Speicher (131) und am vierten Flash-Speicher (133) im zweiten Kanalspeichersatz (130) als nicht normal implementiert erkannt wird.

7. Flash-Speicher-Zugangsvorrichtung nach Anspruch 1, wobei der erste Kanalspeichersatz (120), der zweite Kanalspeichersatz (130) und das Steuergerät (110) auf einer Leiterplatte konfiguriert sind.

8. Flash-Speicher-Zugangsvorrichtung nach Anspruch 1, wobei der erste Kanalspeichersatz (120) und das Steuergerät (110) auf einer Leiterplatte konfiguriert sind und der zweite Kanalspeichersatz (130) ein offener NICHT-UND-Flash-Speicher-Interface-Satz ist.

9. Flash-Speicher-Zugangsvorrichtung nach Anspruch 1, wobei das Steuergerät (110) auf einer Leiterplatte konfiguriert ist und der erste Kanalspeichersatz (120) und der zweite Kanalspeichersatz (130) ein offener NICHT-UND-Flash-Speicher-Interface-Satz ist.

10. Flash-Speicher-Zugangsvorrichtung nach Anspruch 1, wobei das Steuergerät (110) auf einer Leiterplatte konfiguriert ist und der erste Kanalspeichersatz (120) und der zweite Kanalspeichersatz (130) ein offener NICHT-UND-Flash-Speicher-Interface-Satz und direkt auf der Leiterplatte konfiguriert ist.

11. Zugangsmethode eines Flash-Speichers umfassend:
ein Steuergerät zur Implementierung eines Lese- oder Programmierbetriebs an einem ersten Flash-Speicher und einem zweiten Flash-Speicher eines ersten Kanalspeichersatzes und an einem dritten Flash-Speicher und einem vierten Flash-Speicher eines zweiten Kanalspeichersatzes (Schritt S410);
zur Bestimmung, ob der erste Flash-Speicher, der zweite Flash-Speicher, der dritte Flash-Speicher und der vierte Flash-Speicher im ersten Kanalspeichersatz und im zweiten Kanalspeichersatz durch das Steuergerät nach dem Lese- oder Programmierbetrieb (Schritt S420) normal betrieben wird und
zur Bestimmung des ersten Flash-Speichers, des zweiten Flash-Speichers, des dritten Flash-Speichers und des vierten Flash-Speichers als Hauptspeicher oder Sicherungsspeicher durch das Steuergerät, je nachdem, ob der erste Flash-Speicher, der zweite Flash-Speicher, der dritte Flash-Speicher und der vierte Flash-Speicher normal betrieben wird (Schritt S430).

12. Zugangsmethode nach Anspruch 11, ferner umfassend:
Schalten des Sicherungsspeichers als Hauptspeicher durch das Steuergerät, wenn das Steuergerät erkennt, dass der Lese- oder Programmierbetrieb nicht normal am Hauptspeicher implementiert ist.

13. Zugangsmethode nach Anspruch 11, wobei der Schritt zur Bestimmung des ersten Flash-Speichers, des zweiten Flash-Speichers, des dritten Flash-Speichers und des vierten Flash-Speichers als Hauptspeicher oder als Sicherungsspeicher durch das Steuergerät, je nachdem, ob der erste Flash-Speicher, der zweite Flash-Speicher, der dritte Flash-Speicher und der vierte Flash-Speicher normal betrieben wird, folgendes umfasst:
Bestimmung des ersten Flash-Speichers und des dritten Flash-Speichers als Hauptspeicher und Bestimmung des zweiten Flash-Speichers und des vierten Flash-Speichers als Sicherungsspeicher durch das Steuergerät, wenn das Steuergerät erkennt, dass der Lese- oder Programmierbetrieb am ersten Flash-Speicher, am zweiten Flash-Speicher, am dritten Flash-Speicher und am vierten Flash-Speicher normal implementiert ist.

14. Zugangsmethode nach Anspruch 11, wobei der zweite Flash-Speicher dazu verwendet wird, eine Kopie der im ersten Flash-Speicher gespeicherten Daten zu speichern und der vierte Flash-Speicher dazu verwendet wird, eine Kopie der im dritten Flash-Speicher gespeicherten Daten zu speichern.

15. Zugangsmethode nach Anspruch 11, wobei der Schritt zur Bestimmung des ersten Flash-Speichers, des zweiten Flash-Speichers, des dritten Flash-Speichers und des vierten Flash-Speichers als Hauptspeicher oder Sicherungsspeicher durch das Steuergerät, je nachdem, ob der erste Flash-Speicher, der zweite Flash-Speicher, der dritte Flash-Speicher und der vierte Flash-Speicher normal betrieben wird, folgendes umfasst:
Bestimmung des dritten Flash-Speichers als Hauptspeicher und Bestimmung des vierten Flash-Speichers als Sicherungsspeicher durch das Steuergerät, wenn das Steuergerät erkennt, dass der Lese- oder Programmierbetrieb nicht normal am ersten Flash-Speicher und am zweiten Flash-Speicher im ersten Kanalspeichersatz implementiert ist.

16. Zugangsmethode nach Anspruch 11, wobei der Schritt zur Bestimmung des ersten Flash-Speichers, des zweiten Flash-Speichers, des dritten Flash-Speichers und des vierten Flash-Speichers als Hauptspeicher oder Sicherungsspeicher durch das Steuergerät, je nachdem, ob der erste Flash-Speicher, der zweite Flash-Speicher, der dritte Flash-Speicher und der vierte Flash-Speicher normal betrieben wird, folgendes umfasst:
Bestimmung des ersten Flash-Speichers als Hauptspeicher und Bestimmung des zweiten Flash-Speichers als Sicherungsspeicher durch das Steuergerät, wenn das Steuergerät erkennt, dass der Lese- oder Programmierbetrieb am dritten Flash-Speicher und am vierten Flash-Speicher im zweiten Kanalspeichersatz nicht normal implementiert ist.

17. Zugangsmethode nach Anspruch 11, ferner umfassend:
mindestens einen Erweiterungsspeicher als Sicherungsspeicher im ersten Kanalspeichersatz.

18. Zugangsmethode nach Anspruch 11, ferner umfassend:
mindestens einen Erweiterungsspeicher als Sicherungsspeicher im zweiten Kanalspeichersatz.

## Revendications

1. Un appareil d'accès aux mémoires flash, comprenant :
un contrôleur (110) ;
un premier ensemble de mémoires à canaux (120) couplé au contrôleur (110) par le biais d'un premier canal (150), le premier ensemble de mémoires à canaux (120) comprenant :
une première mémoire flash (121) couplée au contrôleur (110), et
au moins une fiche extensible de première mémoire flash (121) couplée à la première mémoire flash (121) et au contrôleur (110), et
un deuxième ensemble de mémoires à canaux (130) couplé au contrôleur (110) par le biais d'un deuxième canal (160), le deuxième ensemble de mémoires à canaux (130) comprenant :
une deuxième mémoire flash (131) couplée au contrôleur (110), et
au moins une fiche extensible de deuxième mémoire flash (131) couplée à la deuxième mémoire flash (131) et au contrôleur (110) ;
**caractérisé en ce que** le contrôleur (110) est adapté pour définir une opération de lecture ou une opération de programmation à mettre en oeuvre sur la première mémoire flash (121) et la deuxième mémoire flash (131), conformément à une détection d'un état d'insertion dans la mémoire flash de la fiche extensible (122) de la première mémoire et de la fiche extensible (132) de la deuxième mémoire puis **en ce que**, lorsque la fiche extensible (122) de la première mémoire est raccordée à une troisième mémoire flash (123) et que la fiche extensible (132) de la deuxième mémoire est raccordée à une quatrième mémoire flash (133), le contrôleur (110) est adapté pour définir la première mémoire flash (121), la deuxième mémoire flash (131), la troisième mémoire flash (123) ou la quatrième mémoire flash (133) comme étant une mémoire principale ou une mémoire de sauvegarde, selon que ce soit l'opération de lecture ou l'opération de programmation qui soit normalement mise en oeuvre sur la première mémoire flash (121), la deuxième mémoire flash (131), la troisième mémoire flash (123) et la quatrième mémoire flash (133).

2. Appareil d'accès aux mémoires flash selon revendication 1, **caractérisé en ce que** le contrôleur (110) commute la mémoire de sauvegarde pour être la mémoire principale lorsqu'il est détecté que l'opération de lecture ou l'opération de programmation est anormalement mise en oeuvre sur la mémoire principale.

3. Appareil d'accès aux mémoires flash selon revendication 1, **caractérisé en ce que** le contrôleur (110) définit la première mémoire flash (121) et la deuxième mémoire flash (131) comme étant les mémoires principales, et définit la troisième mémoire flash (123) et la quatrième mémoire flash (133) comme étant les mémoires de sauvegarde lorsqu'il est détecté que l'opération de lecture ou l'opération de programmation est normalement mise en oeuvre sur la première mémoire flash (121), la deuxième mémoire flash (131), la troisième mémoire flash (123) et la quatrième mémoire flash (133).

4. Appareil d'accès aux mémoires flash selon revendication 3, **caractérisé en ce que** la troisième mémoire flash (123) est utilisée pour mémoriser une copie des données mémorisées dans la première mémoire flash (121) et que la quatrième mémoire flash (133) est utilisée pour mémoriser une copie des données mémorisées dans la deuxième mémoire flash (131).

5. Appareil d'accès aux mémoires flash selon revendication (1), **caractérisé en ce que** le contrôleur (110) définit la deuxième mémoire flash (131) comme étant la mémoire principale et définit la quatrième mémoire flash (133) comme étant la mémoire de sauvegarde lorsqu'il est détecté que l'opération de lecture ou l'opération de programmation est anormalement mise en oeuvre sur la première mémoire flash (121) et la troisième mémoire flash (123) du premier ensemble de mémoires à canaux (120)

6. Appareil d'accès aux mémoires flash selon revendication (1), **caractérisé en ce que** le contrôleur (110) définit la première mémoire flash (121) comme étant la mémoire principale et définit la troisième mémoire flash (123) comme étant la mémoire de sauvegarde, lorsqu'il est détecté que l'opération de lecture ou l'opération de programmation est anormalement mise en oeuvre sur la deuxième mémoire flash (131) et la quatrième mémoire flash (133) du deuxième ensemble de mémoires à canaux (130).

7. Appareil d'accès aux mémoires flash selon revendication (1), **caractérisé en ce que** le premier ensemble de mémoires à canaux (120), le deuxième ensemble de mémoires à canaux (130) et le contrôleur (110) sont configurés sur une carte de circuit imprimé.

8. Appareil d'accès aux mémoires flash selon revendication (1), **caractérisé en ce que** le premier ensemble de mémoires à canaux (120) et le contrôleur (110) sont configurés sur une carte de circuit imprimé et que le deuxième ensemble de mémoires à canaux (130) est un ensemble d'interfaces de mémoires flash NAND de type ouvert

9. Appareil d'accès aux mémoires flash selon revendication (1), **caractérisé en ce que** le contrôleur (110) est configuré sur une carte de circuit imprimé et que le premier ensemble de mémoires à canaux (120) et le deuxième ensemble de mémoires à canaux (130) sont des ensembles d'interfaces de mémoires flash NAND de type ouvert.

10. Appareil d'accès aux mémoires flash selon revendication (1), **caractérisé en ce que** le contrôleur (110) est configuré sur une carte de circuit imprimé et que le premier ensemble de mémoires à canaux (120) et le deuxième ensemble de mémoires à canaux (130) et le deuxième ensemble de mémoires à canaux (130) sont des ensembles d'interfaces de mémoires flash NAND de type ouvert et qu'ils sont directement configurés sur la carte de circuit imprimé.

11. Une méthode d'accès d'une mémoire flash consistant à
fournir un contrôleur pour mettre en oeuvre une opération de lecture ou une opération de programmation sur une première mémoire flash et une deuxième mémoire flash d'un premier ensemble de mémoires à canaux, et sur une troisième mémoire flash et une quatrième mémoire flash d'un deuxième ensemble de mémoires à canaux (étape S410) ;
définir, par le contrôleur, si la première mémoire flash, la deuxième mémoire flash, la troisième mémoire flash et la quatrième mémoire flash, respectivement du premier ensemble de mémoires à canaux et du deuxième ensemble de mémoires à canaux, sont normales, conformément à l'opération de lecture ou l'opération de programmation (étape S420), et
définir, par le contrôleur, la première mémoire flash, la deuxième mémoire flash, la troisième mémoire flash ou la quatrième mémoire flash comme étant une mémoire principale ou une mémoire de sauvegarde, selon que ce soit la première mémoire flash, la deuxième mémoire flash, la troisième mémoire flash ou la quatrième mémoire flash qui soit normalement activée (étape S430).

12. Méthode d'accès selon revendication 11, consistant par ailleurs à
commuter, par le contrôleur, la mémoire de sauvegarde pour être la mémoire principale, lorsque le contrôleur détecte que l'opération de lecture ou l'opération de programmation est anormalement mise en oeuvre sur la mémoire principale.

13. Méthode d'accès selon revendication 11, **caractérisée en ce que** l'étape de définition, par le contrôleur, de celle de la première mémoire flash, de la deuxième mémoire flash, de la troisième mémoire flash et de la quatrième mémoire flash qui est une mémoire principale ou une mémoire de sauvegarde, selon que ce soit la première mémoire flash, la deuxième mémoire flash, la troisième mémoire flash ou la quatrième mémoire flash qui est normalement activée, consistant à
définir la première mémoire flash et la troisième mémoire flash comme étant les mémoires principales et à définir la deuxième mémoire flash et la quatrième mémoire flash comme étant les mémoires de sauvegarde, par le contrôleur, lorsque le contrôleur détecte que l'opération de lecture ou l'opération de programmation est normalement mise en oeuvre sur la première mémoire flash, la deuxième mémoire flash, la troisième mémoire flash et la quatrième mémoire flash.

14. Méthode d'accès selon revendication 11, **caractérisée en ce que** la deuxième mémoire flash est utilisée pour mémoriser une copie des données mémorisées dans la première mémoire flash et que la quatrième mémoire flash est utilisée pour mémoriser une copie des données mémorisées dans la troisième mémoire flash.

15. Méthode d'accès selon revendication 11, **caractérisée en ce que** l'étape de définition, par le contrôleur, de la première mémoire flash, de la deuxième mémoire flash, de la troisième mémoire flash ou de la quatrième mémoire flash comme étant une mémoire principale ou une mémoire de sauvegarde, selon que ce soit la première mémoire flash, la deuxième mémoire flash, la troisième mémoire flash ou la quatrième mémoire flash qui soit normalement activée, consistant à
définir la troisième mémoire flash comme étant la mémoire principale et à définir la quatrième mémoire flash comme étant la mémoire de sauvegarde, par le contrôleur, lorsque le contrôleur détecte que l'opération de lecture ou l'opération de programmation est anormalement mise en oeuvre sur la première mémoire flash et la deuxième mémoire flash du premier ensemble de mémoires à canaux.

16. Méthode d'accès selon revendication 11, **caractérisée en ce que** l'étape de définition, par le contrôleur, de la première mémoire flash, de la deuxième mémoire flash, de la troisième mémoire flash ou de la quatrième mémoire flash comme étant une mémoire principale ou une mémoire de sauvegarde, selon que ce soit la première mémoire flash, la deuxième mémoire flash, la troisième mémoire flash ou la quatrième mémoire flash qui soit normalement activée, consistant à
définir la première mémoire flash comme étant la mémoire principale et à définir la deuxième mémoire flash comme étant la mémoire de sauvegarde, par le contrôleur, lorsque le contrôleur détecte que l'opération de lecture ou l'opération de programmation est anormalement mise en oeuvre sur la troisième mémoire flash et la quatrième mémoire flash du deuxième ensemble de mémoire à canaux.

17. Méthode d'accès selon revendication 11, consistant par ailleurs à
fournir au moins une mémoire extensible pour être la mémoire de sauvegarde du premier ensemble de mémoires à canaux.

18. Méthode d'accès selon revendication 11, consistant par ailleurs à
fournir au moins une mémoire extensible pour être la mémoire de sauvegarde du deuxième ensemble de mémoires à canaux.
